# EUROPEAN PATENT SPECIFICATION

(11) **EP 2 589 093 B1**
(45) Date of publication and mention of the grant of the patent: **20.08.2014**
(21) Application number: 11743128.8
(22) Date of filing: 30.06.2011
(51) Int. Cl.: H01L 51/00, H01L 51/44, H01L 51/42

(54) **TRANSPARENT ELECTRODES FOR SEMICONDUCTOR THIN FILM DEVICES**
TRANSPARENTE ELEKTRODEN FÜR DÜNNSCHICHT-HALBLEITERBAUELEMENTE
ELECTRODES TRANSPARENTES POUR DISPOSITIFS À FILM MINCE SEMI-CONDUCTEURS

(30) Priority: 30.06.2010 GB 201011118
(43) Date of publication of application: 08.05.2013
(73) Proprietor: The University Of Warwick, Coventry, Warwickshire CV4 7AL (GB)
(72) Inventor: HATTON, Ross, Andrew, Church Lawford Warwickshire CV23 9EG (GB); STEC, Helena, Maria, Coventry Warwickshire CV4 9BT (GB); JONES, Timothy, Simon, Gaydon Warwickshire CV35 0EY (GB)
(74) Representative: Butler, Michael John
(86) International application number: PCT/GB2011/051245
(87) International publication number: WO 2012/001424

(56) References cited:
- ROSS A. HATTON ET AL: "A robust ultrathin, transparent gold electrode tailored for hole injection into organic light-emitting diodes", JOURNAL OF MATERIALS CHEMISTRY, vol. 13, no. 4, 19 March 2003 (2003-03-19) , pages 722-726, XP55008096, ISSN: 0959-9428, DOI: 10.1039/b211775b
- HADIPOUR A ET AL: "SOLUTION-PROCESSED ORGANIC TANDEM SOLAR CELLS", ADVANCED FUNCTIONAL MATERIALS, WILEY - V C H VERLAG GMBH & CO. KGAA, DE, vol. 16, 1 January 2006 (2006-01-01), pages 1897-1903, XP001245910, ISSN: 1616-301X, DOI: 10.1002/ADFM.200600138
- OÂ CONNOR BRENDAN ET AL: "Transparent and conductive electrodes based on unpatterned, thin metal films", APPLIED PHYSICS LETTERS, AIP, AMERICAN INSTITUTE OF PHYSICS, MELVILLE, NY, US, vol. 93, no. 22, 4 December 2008 (2008-12-04), pages 223304-223304, XP012112724, ISSN: 0003-6951, DOI: 10.1063/1.3028046
- KLAUK H ET AL: "Ion-beam-deposited ultrathin transparent metal contacts", THIN SOLID FILMS, ELSEVIER-SEQUOIA S.A. LAUSANNE, CH, vol. 366, no. 1-2, 1 May 2000 (2000-05-01) , pages 272-278, XP004203869, ISSN: 0040-6090, DOI: 10.1016/S0040-6090(00)00728-8

## Description

This invention relates to transparent electrodes for semiconductor thin film devices, particularly but not exclusively for use in the construction of photo-sensitive devices such as photovoltaic cells. More particularly the invention concerns transparent electrodes for semiconductor thin film devices incorporating an organic semiconductor, for example organic photovoltaic devices.

Organic photovoltaics (OPVs) are receiving growing interest as a potential future means of generating electricity directly from sunlight. The operating principle of these devices is based on photo-excitation of the active organic layer consisting of a junction between donor and acceptor type organic semiconductors. The basic design of an organic photovoltaic cell consists of an organic layer sandwiched between two electrodes. In order to allow light into the cell, at least one electrode must be transparent and conductive.

Early work was based on single molecular organic layers, typically made of phthalocyanines (Pc) or polyacenes, sandwiched between two electrodes. In the 1980s a device comprising a bilayer (planar) heterojunction was developed, using copper phthalocyanine (CuPc) and a perylene derivative, resulting in an order of magnitude improvement in power conversion efficiency. The discovery of C₆₀ in 1985 and its use in a CuPc/C₆₀ planar heterojunction device further increased the power conversion efficiency achievable.

The majority of OPV devices operate by combining organic materials which have donor and acceptor properties and providing a heterojunction between two such organic layers, where one layer is an electron transporter (acceptor) and the other is a hole transporter (donor). In particular, known organic photovoltaic cells are based on thin films of organic semiconducting materials, such as phthalocyanines and fullerenes, or conjugated polymers and fullerenes. The donor-acceptor films are typically 100 nm in thickness.

Upon absorption of light into an organic PV device an exciton, i.e. a bound electron - hole pair, is generated. The electron and hole are bound together by electrostatic attraction and are strongly localised. The exciton is able to migrate or diffuse within the organic layer during which time it must reach a donor-acceptor interface in order to dissociate efficiently into free charge carriers. This dissociation is essential in photovoltaic cells such that when an exciton reaches an interface between the donor material and acceptor material, the electron of the electron-hole pair (exciton) may be transferred to the acceptor material. The electron in the acceptor material is transported to the electron extracting electrode, and the hole, remaining in the donor material, is transported to the hole-extracting electrode. The diffusion length of an exciton is of the order of 10 to 50 nm; for example in copper phthalocyanine (CuPc) it has been found experimentally to be about 30 nm. Beyond this length the probability of the electron-hole pair recombining increases. It may therefore appear desirable to reduce the film thickness to less than 30 nm in order that the exciton reaches a donor-acceptor interface and dissociates. However, in order to absorb light efficiently and hence create excitons, film thicknesses of typically 100 nm are required.

In WO 2008/029161, there is disclosed a thin film structure for use in organic photovoltaic cells, comprising first and second continuous interpenetrating lattices of semiconductor materials acting as respective electron donor and acceptor materials. WO 2008/029161 discloses that in the process described there are two possibilities for organic photovoltaic cells, namely both the donor and acceptor materials are organic semiconductors (type 1), or one of the donor and acceptor materials is an organic semiconductor and the other is an inorganic semiconductor (type 2). WO 2008/029161 also discloses that the principle may also apply to photovoltaic cells in which both the donor and acceptor materials are inorganic semiconductors (type 3).

In WO 2008/029161 it is said that the transparent electrode may be ITO (indium-tin oxide) coated glass. In practice, ITO coated glass is invariably employed currently as the transparent electrode in organic photovoltaics, primarily due to the absence of a viable alternative. ITO is a complex ternary oxide that is inherently unstable and chemically ill-defined and is not well suited to organic photovoltaic applications for a number of reasons :-
(i) Its surface is chemically ill-defined with a significant proportion of insulating or poorly conducting patches.
(ii) Indium, tin and oxygen species may leach into the photoactive organic layers and contaminate them to the detriment of device performance.
(iii) Indium is increasingly expensive due to demand from, for example, the flat screen display industry. Indeed, the global supply is expected to fall well short of projected demand in the coming years, thus creating a bottleneck to the proliferation of organic photovoltaics once efficiency targets for market entry are met.
(v) The surface roughness of ITO glass is not ideal for organic photovoltaics which typically have a photoactive layer thickness of less than 200 nm.
(vi) ITO is not compatible with flexible plastics substrates since in order to achieve the necessary conductivity the oxide film must be at least 100 nm thick, rendering it prone to cracking upon bending.

Possible replacements for ITO include other transparent conducting oxides, conducting polymers, metallic micro-grids combined with conducting polymers, carbon nanotubes films and graphene. Unfortunately, very few of these electrodes have yielded devices with performance comparable to those utilising ITO glass.

It has been proposed to use ultra-thin (no greater than about 10 nm thick) films of atmospherically stable metals such as gold and silver as transparent electrodes. However, such ultra-thin metal films are typically very fragile and prohibitively resistive. This is due to poor film quality which results from an unfavourable disparity in surface energy and poor adhesion with the substrate. Hatton et al in J. Mater Chem. 2003, 13, 722-726 have proposed a way to circumvent this issue in the context of organic light emitting diodes, by chemically modifying the surface onto which the metal is deposited with "sticky" molecules that immobilise the metal atoms upon arrival thereby seeding the growth of a continuous metal film of low thickness. Certain silanes can be used for this purpose and Hatton et al discloses the production of ultra-thin gold films on glass substrates, using a thiol functionalised methoxysilane layer (MPTMS). However, in Hatton et al the MPTMS was applied to the substrate by dipping the substrate in a solution of MPTMS in anhydrous toluene. This method is not amenable to scale-up because of the length of time required for the glass substrate to be derivatized with the MPTMS layer, the requirement to use large amounts of solvent and the potential for MPTMS polymerisation, which increases the sheet resistance and surface roughness of the gold film.

According to one aspect of the present invention there is provided a method of producing a transparent electrode suitable for use in an organic photovoltaic device, comprising the steps of co-depositing on a transparent substrate, from the vapour phase, first and second silanes that bind to the surface of the substrate, and subsequently depositing from the vapour phase a metal film which binds to both the first and second silanes so as to produce a transparent metal layer having a thickness which is no greater than about 15 nanometres, wherein the first silane is a non-amino functional silane and the second silane is an aminofunctional silane.

Both the first and second silanes each have at least one "anchor group" which is a functional moiety capable of binding to the surface of the substrate or which is hydrolysable to form such a moiety. Binding will typically be via a covalent linkage. Up to three such anchor groups, which may be the same or different, may be present in each of the first and second silanes; these will generally be directly linked to the Si atom in the silane. Preferably, there will be more than one such anchor group in each silane, typically two or three, e.g. three. Where more than one anchor group is present in any given silane, these will preferably be identical. The use of silanes which have three identical anchor groups directly attached to the Si atom is particularly preferred.

Bifunctional silanes which contain two Si atoms may also be employed in the invention. One or both of the first and second silanes may be bifunctional and as such may provide greater than three anchor groups per molecule. For example, bifunctional silanes may comprise up to six anchoring groups (in the case where these groups are attached directly to each Si atom). Monofunctional silanes (i.e. those having a single Si atom) are, however, generally preferred.

Typical substrate materials include glass and polymer materials which either carry pendant hydroxy groups or which may be functionalised or treated (e.g. by oxygen plasma treatment or by ultra-violet light/ozone (03) treatment) whereby to introduce such groups onto the polymer backbone using methods known in the art. Any hydroxy groups present on the silanes may be capable of binding to such substrate materials and thus acting as suitable anchor groups without the need for pretreatment. Functional groups which are capable of binding to the substrate materials (e.g. following hydrolysis to produce a silanol) are particularly suitable for use as anchor groups; these include in particular alkoxy (preferably C₁₋₄ alkoxy or phenoxy), halogen (e.g. Cl) and -H. Particularly preferred amongst these are alkoxy, in particular methoxy and ethoxy, more preferably methoxy.

In addition to the anchor group(s), the first and second silanes each possess at least one "head group" capable of binding to the metal. Binding will typically be via a covalent bond. In the case of the second silane, the head group is provided by a primary amine moiety. In addition to the amine moiety (or moieties), other functional groups capable of binding to the metal may also be present in the second silane; however, this is generally less preferred.

In contrast to the second silane, the first silane does not include any amino functionality. However, it too should be capable of binding to the metal, preferably via a covalent bond, and this is achieved through the presence of at least one "head group" which is a non-amino functional moiety, such as a thiol (-SH), carboxy (-CO₂H), isocyanide (-NC) or organo-disulphide (-SS-R) group (where R is as herein defined, preferably a silicon-containing group). Of these, thiol is particularly preferred.

The first silane alone produces a structure that is resistant to further processing steps such as ultrasonic agitation in a suitable solvent prior to fabrication of an organic photovoltaic device. However, the first silane can take an extended period in order to bind to the surface of the substrate by chemical derivatization. By contrast, the second silane binds rapidly to the surface of the substrate as the amine moiety catalyses the coupling reaction, but used alone produces a structure that is less robust in the context of further processing steps such as ultrasonic agitation to clean the electrode. The amine moiety of the second silane also catalyses the coupling reaction of the first silane to the surface of the substrate, with the result that both silanes bind rapidly to the surface. Overall there is increased robustness in the context of ultrasonic agitation and other processing steps in the manufacture of an organic photovoltaic device.

The first silane may have the formula (I): 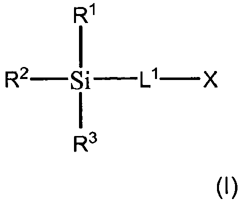 (wherein
L¹ is a linker group;
X is selected from -SH, -CO₂H, -NC and -SS-R where R is hydrogen, C₁₋₆ alkyl or a silicon-containing group); and
each of R¹ to R³ is independently an organic group having 1 to 12 carbon atoms, -OH, a group hydrolysable to -OH, or a group -L¹-X;
with the proviso that at least one of R¹, R² and R³ is -OH or a group hydrolysable to -OH).

Where X is a group -SS-R, it is preferred that R should be a silicon-containing group such that following cleavage of the disulphide bond the resulting compound HS-R may also function to bind the metal to the surface of the substrate. Thus, R will preferably be a group having at least one "anchor group" as herein described. Typically, R may be a group -L¹-SiR¹R²R³ in which L¹ is as herein defined and each of R¹, R² and R³ is independently an organic group having 1 to 12 carbon atoms, -OH or a group hydrolysable to -OH.

Groups hydrolysable to -OH include -H, halogen (especially Cl) and alkoxy (especially C₁₋₄ alkoxy or phenoxy). Of these, alkoxy is particularly preferred.

In the compounds of formula I, the function of L¹ is as a linking moiety and its precise chemical nature is of lesser importance provided that this function is fulfilled. Generally, however, it will comprise a chain 1 to 10 atoms long, preferably 1 to 8 atoms long, especially 1 to 5. Examples of suitable linkers include both linear and branched alkane (i.e. (CH2)ₚ where p is an integer) chains which may be interrupted by heteroatoms such as nitrogen and oxygen or by aryl groups. Suitable interrupting groups include -O- and -NR⁷- where R⁷ is either hydrogen or C₁₋₆ alkyl (e.g. methyl). In the case where the linker is interrupted by an aryl group, this will typically be an optionally substituted phenyl or biphenyl, e.g. unsubstituted phenyl or biphenyl. Where any biphenyl group is present this will generally be paralinked. Where the linkers are branched, it is generally preferred that the pendant groups will comprise a chain having a maximum of 4 atoms, more preferably 1-3 atoms. Suitable pendant groups include, for example, methyl.

Preferred linkers L¹ include -(CH₂)ₚ- where p is an integer from 1 to 4, preferably 2 to 4, e.g. 3. Other preferred linkers L¹ include -(CH₂)_{q}-(Ph)ᵣ-(CH₂)ₛ- where Ph is phenyl; r is 1 or 2, preferably 1; q and s are each independently an integer from 0 to 3, preferably from 0 to 2; with the proviso that q and s cannot both be 0. Particularly preferred linkers are -CH₂-, -CH₂CH₂CH₂-, -CH₂-Ph-CH₂CH₂- and -CH₂-Ph-Ph-.

In formula I, X is preferably -SH. Preferably each of R¹ to R³ is independently a group hydrolysable to -OH, for example C₁₋₄ alkoxy. More preferably, R¹ to R³ are identical and are each C₁₋₄ alkoxy, e.g. methoxy.

In a preferred embodiment the first silane is thus a compound of the formula la:

(R'O)ₐSi -(L¹-X)₄₋ₐ (Ia)

(wherein
a is an integer from 1 to 3, preferably 3;
R' is C₁₋₄ alkyl, preferably methyl;
L¹ is as hereinbefore defined, preferably C₂₋₈ alkylene, e.g. C₂₋₄ alkylene; and
X is as hereinbefore defined, preferably -SH).

Examples of the first silane include the following:
HS-(CH₂)₃-Si(OCH₃)₃ (3-mercaptopropyltrimethoxysilane);
HS-CH₂-(C₆H₄)-Si(OCH₃)₃; and
HS-CH₂-(C₆H₄)-(CH₂)₂-Si(OCH₃)₃.

The second silane may have the formula (II): 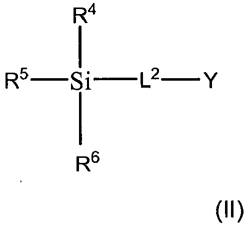 (wherein
L² is a linker group;
Y is -NH₂; and
each of R⁴ to R⁶ is independently an organic group having 1 to 12 carbon atoms, -OH, a group hydrolysable to -OH, or a group -L²-Y;
with the proviso that at least one of R⁴, R⁵ and R⁶ is -OH or a group hydrolysable to -OH).

In formula II, the groups hydrolysable to -OH may have the same meaning given above for R¹ to R³ in formula I.

As with L¹, the function of L² in formula II is as a linking moiety. L² may have the meaning given above for L¹.

Preferably each of R⁴ to R⁶ is independently a group hydrolysable to -OH, for example C₁₋₄ alkoxy. More preferably, R⁴ to R⁶ are identical and are each C₁₋₄ alkoxy, e.g. methoxy.

In a preferred embodiment the second silane is thus a compound of the formula IIa:

(R"O)_{b}Si -(L²-Y)_{4-b} (IIa)

(wherein
b is an integer from 1 to 3, preferably 3;
R" is C₁₋₄ alkyl, preferably methyl;
L² is as hereinbefore defined, preferably C₂₋₈ alkylene, e.g. C₂₋₄ alkylene; and
Y is -NH₂).

Examples of the second silane include the following:
NH₂-(CH₂)₃-Si(OCH₃)₃ (3-aminopropyltrimethoxysilane);
N H₂-(CH₂)₃-Si(OC₂H₅)₃;
NH₂-(CH₂)₃-Si(OC₂H₅)₂(CH₃);
NH₂-CH₂-(C₆H₄)-Si(OCH₃)₃; and
NH₂-CH₂-(C₆H₄)-(CH₂)₂-Si(OCH₃)₃.

Of these, 3-aminopropyltrimethoxysilane is particularly preferred.

Particularly preferred for use in the method is a mixture of the first and second silanes in a ratio of about 90:10 to about 10:90, more preferably 75:25 to about 25:75. A preferred ratio of first silane to second silane is about 25:75.

A preferred combination of silanes for use in the invention is that in which the first silane is 3-mercaptopropyltrimethoxysilane (MPTMS) and the second silane is 3-aminopropyltrimethoxysilane (APTMS).

The silanes herein described are available commercially, e.g. from Dow Corning Corporation or Degussa AG, or may be made by methods well known in the art.

An alternative to the use of first and second silanes is the use of a single silane which is capable of binding to the surface of the substrate and to the metal and which comprises both amino and non-amino functionalities. The presence of an amine moiety (which may be either a primary or a secondary amine) catalyses coupling of the silane to the surface of the substrate. Where the amine is a primary amine, this will also be capable of binding to the metal. Secondary amines may, however, be used in this aspect of the invention to the extent that these still serve to catalyse the coupling reaction. Secondary amine groups may, for example, be present within a linker moiety which serves to link the anchor group(s) at one end of the silane molecule to the head group(s) at the other. Silanes for use in this particular aspect of the invention will comprise at least one "anchor group" and one or more "head groups" as herein described. For example, these may contain two different head groups both capable of binding to a metal. Where two or more such head groups are present, at least one of these may be an amino functional moiety (e.g. a primary amine) and at least one of the remaining head groups may be a non-amino functional moiety, such as a thiol (-SH), carboxy (-CO₂H), isocyanide (-NC) or organo-disulphide (-SS-R) group (especially thiol).

Thus, according to another aspect of the present invention there is provided a method of producing a transparent electrode suitable for use in an organic photovoltaic device, comprising the steps of depositing on a transparent substrate, from the vapour phase, a silane that binds to the surface of the substrate, and subsequently depositing from the vapour phase a metal film which binds to the silane so as to produce a transparent metal layer having a thickness which is no greater than about 15 nanometres, wherein the silane comprises both amino and non-amino functionalities.

In a preferred embodiment of the invention there are two silanes and the first silane is MPTMS whereas the second silane is APTMS. APTMS and MPTMS molecules bind covalently to native hydroxyl groups at the surface of glass via the methoxysilane moieties (-OCH3). The -HN2 (APTMS) or -SH (MPTMS) moieties are then free to bind to incoming gold atoms during metal deposition. APTMS has the advantage that the amine moiety also catalyses the coupling reaction to the surface and so the glass surface can be derivatized with APTMS very rapidly. However, the resulting ultra-thin gold films are not resistant to ultra-sonication in water and so are not sufficiently robust for application in organic photovoltaic devices. Ultra-thin films prepared using MPTMS are robust to ultra-sonication in water but the process of chemical derivatization is much slower. When APTMS and MPTMS are co-deposited in accordance with the invention, chemical derivatization of the glass surface is rapid and the ultra-thin gold films are robust towards ultra-sonication in water. A further advantage of using an APTMS : MPTMS mixed monolayer is that the thermal stability of the ultra-thin Au films is much greater than when using a monolayer of only one molecule type (i.e. APTMS or MPTMS alone).

Depositing the silanes from the vapour phase make it easier to form a very thin silane layer, preferably a mono-molecular layer, without polymerisation occurring. This ensures that the roughness of the metal overlayer is very similar to that of the underlying substrate. Vapour phase deposition of the silanes can be carried out in a closed vessel at atmospheric pressure if the silanes are heated moderately, for example to no more than about 100°C. Alternatively, silane deposition can be carried out under vacuum, with or without heating. Depositing the metal from the vapour phase, e.g. by thermal evaporation, ensures that the thin silane layer is not damaged such to impair its function, as would be the case with sputtering of the metal, for example.

The metal layer is preferably of a metal that is resistant to corrosion and oxidation, such as gold, silver or another noble metal suitable for deposition from the vapour phase for use as a transparent electrode in an organic semiconductor. It has also been found that copper can be used as the metal.

In some embodiments, a mixture of metals is used. For example there could be an alloy of gold and silver; gold and copper; silver and copper; or gold, silver and copper. A preferred alloy is of gold and silver. For example, ultra-thin silver films are transparent over a different part of the visible spectrum to ultra-thin gold films of the same thickness. An alloy allows broader band optical transparency. By alloying metals it is also possible to tune the work function continuously between that of the two metals (e.g. between 5.1 eV (gold) and 4.6 eV (silver)). This is an important feature because it allows the Fermi level of the electrode to be tuned to the relevant frontier molecular orbital energy in the adjacent organic semiconductor, which impacts device efficiency. Instead of an alloy, the different metals could be deposited separately, either simultaneously or sequentially.

Where an alloy of two metals is used, such as gold and silver, the respective mole percentages of the two metals could be about 10:90, 20:80, 25:75, 30:70, 40:60, 50:50, 60:40, 70:30, 75:25, 80:20, or 90:10.

Additionally or alternatively the metals have different work functions and the metals and their proportions are such as to provide a Fermi level for the electrode which is tuned to an organic semiconductor with which the electrode is to be used in an organic photovoltaic device.

In accordance with the above aspects of the invention, the thickness of the metal film is no more than about 15 nm. In preferred embodiments, the thickness is no more than about 10 nm. In general, the thickness of the metallic layer needs to be chosen to meet the three aims of a sufficiently low sheet resistance, and preferably no more than about 100 ohms per square (Ω/sq), more preferably no more than about 20 ohms per square, e.g. no more than about 15 ohms per square; sufficiently high transmission of light across the visible spectrum, such as at least about 70%, more preferably at least about 75% (e.g. at least about 80%); and sufficient robustness. The transmission figures given are relative to the bare substrate, such as glass or polymer. The absolute transmission of light through the electrode - substrate and metal film - will be lower and could, for example, be as low as about 55%.The sheet resistance of the metal layer will typically be in the range 10 to 20 ohms per square. In general, to provide a sufficiently low sheet resistance, the thickness needs to be greater than about 4 nm, typically greater than about 6 nm or about 7 nm. The thickness may be in the range of about 6 nm to about 10 nm, or in the range of about 7 nm to about 9 nm. A typical thickness may be about 8 nm to 8.5 nm.

A problem is that depending on the metal or metals forming the layer, it may be difficult to achieve the optimum transmission characteristics and the optimum sheet resistance simultaneously. Reducing the thickness of the film will increase transmission, but increase sheet resistance, and obtaining the best compromise may not be easy in all circumstances.

In some embodiments, therefore, there is provided an additional variable. In accordance with these embodiments, the ultra-thin metallic film is provided with an array of apertures whose diameter is at least about 300 nm and preferably at least about 500 nm. The diameter in preferred embodiments may be no less than about 550 nm, no less than about 600 nm, no less than about 750 nm, no less than about 1 micron. In general it is preferred to have apertures whose diameters are no less than the wavelength of the light to which e.g. an organic photovoltaic device will be exposed, or at least wavelengths of light around the peak sensitivity or peak sensitivities of the device, since scattering effects may even reduce transmission through the film.

The diameter of the apertures may be no more than about 50 microns, preferably no more than about 10 microns. In preferred embodiments the diameter may be no more than about 5 microns, or no more than about 2.5 microns or no more than about 2 microns, or no more than about 1.5 microns, or no more than about 1 micron.

By using an appropriate number of apertures of an appropriate size, the transmission of light through the film will be increased. That means that the thickness of the film can be increased beyond that which would otherwise be required. Of course, the absence of metal due to the inclusion of the apertures will increase the sheet resistance of the film. However by adjusting the two parameters of the film thickness and the area taken up by apertures, it is possible to obtain an optimum compromise more readily.

The apertures may be provided by using a variety of nanosphere or microsphere lithographic techniques. These include (i) patterning the substrate surface such that the silane can couple only to specific areas; (ii) patterning the silane layer so that metal can only adhere in specific places; or (iii) masking the silane coated substrate during metal deposition so that only specific parts of the substrate are metallized. In one such an arrangement where the substrate is masked, spheres of a suitable material such as polystyrene are attached to the substrate. This may be done before or after the substrate has been treated with the mixture of silanes. The metal film is then deposited, and then the spheres are removed. This may be done mechanically, for example by means of applying and then lifting off an adhesive tape which adheres to the spheres. Alternatively, the spheres may be dissolved by a suitable solvent. If any metal has adhered to the spheres, this will remain after treating with the solvent but can be rinsed off.

The spheres may for example be of polystyrene but other materials may be used, for example another polymer such as polymethylmethacrylate. In some embodiments the spheres may be of a polymer that can be removed by exposure to an organic solvent. This may be in hot vapour form. For, example, in the case of polystyrene spheres vapour from boiling tetrahydrofurane (THF) may be used. Suitable organic solvents, in addition to THF, could be toluene or xylene, for example.

The array of apertures does not need to be ordered, and may be random although it could be ordered if desired. There is no restriction on the density of apertures.

In an alternative arrangement, a thin metal film may be deposited, and then annealed to a temperature such that holes appear in the film, thus increasing transparency.

The annealing temperature may be at least about 100°C, 150°C, 200°C, 250°C, 300°C, 350°C or 400°C. The annealing temperature may be no more than about 250°C, 300°C, 350°C or 400°C.

The invention also extends to a method or producing a photovoltaic device by combining a transparent electrode produced in accordance with any of the above aspects of the invention with a donor semiconductor material, an acceptor semiconductor material, and a second electrode. The second electrode may, for example, be an opaque, reflective electrode of a metal such as silver, aluminium or calcium or any combination thereof. Preferably at least one of the donor and acceptor materials is an organic semiconductor material. An organic acceptor material may be, for example, perylenes, napthalenes, fullerenes, nanotubes or siloles. In some preferred embodiments of the present invention, the acceptor material is Buckminster fullerene (C₆₀). An organic donor material may be, for example, a phthalocyanine, porphyrin or acene or a derivative thereof or a metal complex thereof such as a metal pthalocyanine. One preferred donor material in embodiments of the present invention is chloro-aluminium phthalocyanine, and another is sub-phthalocyanine.

The invention also extends to a transparent electrode produced by a method in accordance with the invention, and to a photovoltaic device, preferably an organic photovoltaic device, comprising such a transparent electrode, a donor semiconductor material, an acceptor semiconductor material, and a second electrode.

Preferably, at least one of the donor semiconductor material and the acceptor semiconductor material is an organic semiconductor material.

The use of the word "diameter" does not imply that the apertures are circular, although in practice they may be formed using spheres as described above. The word "diameter" extends to a more general sense as referring to a maximum dimension.

Aspects of the present invention are particularly advantageous if the substrate is flexible, and in particular a flexible plastic material. In general organic semiconductors offer the prospect of truly flexible photovoltaics which can be disposed of in a sustainable way at the end-of-use. The realization of this potential depends on the availability of suitable transparent substrate electrodes with high electrical conductivity, since the inherent brittleness of conducting oxide electrodes causes them to fail catastrophically upon bending. In recent years a number of new transparent electrode technologies have been proposed for organic photovoltaic devices, although two key aspects of electrode design have largely been overlooked. These are:
(1) The critical importance of electrode sheet resistance. This is often masked by the small area of the laboratory scale flexible OPVs reported to date. For practical applications it is essential that the sheet resistance is minimised, since the charge carrier collection efficiency in OPVs is strongly voltage dependent.
(2) It is now clear that the interface with the substrate electrode is a critical determinant of OPV performance and so stable, well-defined electrodes are a prerequisite to engineering robust, energetically optimized interfaces with the substrate electrode.

In accordance with embodiments of the invention, there are provided nano-thickness, highly transparent metal (such as Au) transparent electrodes on flexible substrates. These include polyethylene naphthalate (PEN) and polyethylene terephthalate (PET) substrates. It has been found that these electrodes are robust towards common solvents (e.g. toluene, water and 2-propanol), repeated bending and elevated temperature. They are also chemically and topographically well-defined.

The key to the realization of these electrodes is derivatization of the surface of the plastic substrate with a mixed silane monolayer, where the silane layer is deposited from the vapour phase. Vapour phase deposition of the mixed silane layer renders the process scalable and compatible with plastic substrates.

In accordance with embodiments of the invention, there is provided a method for the preparation of ultra-thin (such as about 5-9 nm), smooth metal electrodes on transparent flexible polymer substrates such as polyethylene naphthalate (PEN) and polyethylene terephthalate (PET). In preferred embodiments a key step in the preparation of these films is derivatization of the plastic surface with a mixed monolayer of silane molecules of type (I) and (II) prior to metal deposition by evaporation, Said mixed silane layer is deposited from the vapour phase under low vacuum, avoiding complexity resulting from the use of solvents and rendering it scalable. The resulting films are highly electrically conductive and highly transparent across the visible and near infra-red range. They are also robust towards common solvents (e.g. water, isopropanol and toluene), repeated bending and elevated temperatures up to 200 °C. A further important feature of these films is that for thicknesses ≤ about 8 to 9 nm, moderate annealing dramatically extends the transparency in the near infra-red region 700-900 nm and reduces the sheet resistance making them well suited to OPV applications. In preferred embodiments, such a device is fabricated entirely under vacuum, offering the possibility of fabricating all of the device components including the substrate electrode in the same vacuum system. This is an important advantage since it offers a means of reducing the fabrication cost.

PEN and PET are widely regarded as the substrates of choice for flexible organic optoelectronics due to their high transparency, good mechanical properties and resistance to oxygen and water vapour penetration. The substitution of the p-phenylene ring in PET with naphthalene in PEN increases the absorption below 380 nm, thereby filtering out high energy ultra-violet photons which are suspected of reducing device lifetime.

Typically the weak adhesion between evaporated metal films such as Au and plastic substrates results in poor film transparency and high sheet resistance. In preferred embodiments of the invention the plastic substrate surface is treated with a mixed monolayer of silane molecules. Silanes (e.g. chlorosilanes, alkoxysilanes and phenoxysilanes) couple to oxide surfaces via native surface hydroxyl groups which are not present at the surface of PET and PEN and so need to be generated by oxidative treatments such as oxygen plasma or UV/03. In the context of plastic substrates UV/O3 treatment was found to be the most suitable, since it is a milder treatment and does not increase the surface roughness for short treatment times.

Some embodiments of the invention will now be described by way of example and with reference to the accompanying drawings in which:
Figure 1 is a schematic representation of a process in accordance with the invention;
Figure 2 is a graph showing the sheet resistance as a function of deposition time for ultra-thin Au films on MPTMS (6), APTMS (7) and mixed MPTMS : APTMS (8) derivatized glass substrates;
Figure 3 is a graph showing transparency as a function of wavelength, referenced to plain glass;
Figure 4 is a graph showing current-voltage characteristics of an OPV using an ITO coated glass substrate (12) and ultra-thin Au film electrode with holes (13) under 1 sun simulated solar illumination;
Figure 5 is a diagrammatic view of an organic photovoltaic device using a transparent electrode in accordance with the invention;
Figure 6 is a graph showing the transparency of different metal films as a function of the wavelength of light, referenced to plain glass;
Figure 7 is a graph showing the sheet resistance of 8.4 nm Au films supported on glass substrates derivatized with a monolayer of MPTMS (filled squares), APTMS (open squares) and a mixed monolayer of MPTMS : APTMS (open triangles) as a function of annealing temperature;
Figure 8 is a graph showing the effect of thermal annealing on the transparency (referenced to plain glass) and sheet resistance of 8.4 nm Au films on glass substrates derivatized with a monolayer of MPTMS : APTMS as a function of annealing temperature;
Figure 9 is a grazing angle X-ray diffraction *θ*-2*θ* spectra of a non-annealed Au film on glass with an MPTMS : APTMS monolayer; The inset is an X-ray diffraction *θ*-2*θ* spectra of the same sample taken at a non-grazing angle;
Figure 10 is an X-ray diffraction *θ*-2*θ* spectra of an Au film on MPTMS : APTMS derivatized glass annealed to 300°C for 10 minutes;
Figure 11 is a graph showing the change in shape of the transmission spectrum of an 6.5 nm Au film on PEN derivatized with an MPTMS : APTMS monolayer before and after annealing to 200°C - the transparency is referenced to plain glass;
Figure 12 shows the current-voltage characteristics of OPVs with the structure: 8.4 nm Au on PET (or 8.4 nm Au on PETorITO on PET) / 1 nm PTCDA / 43 nm pentacene/ 40 nm C₆₀ / 8 nm bathocuproine / 100 nm Al under 1 sun simulated solar illumination;
Figure 13 is a graph of the power conversion efficiency of 1 cm² OPV devices with a structure: 8.4 nm Au on PET (or 8.4 nm Au on PET, or ITO on PET) / 1 nm PTCDA / 43 nm pentacene/ 40 nm C₆₀ / 8 nm bathocuproine / 100 nm Al under 1 sun simulated solar illumination as a function of the number of times the device is bent through a radius of curvature of 4 mm;
Figure 14 shows the ransmittance spectra of Au films of different thickness deposited onto MPTMS : APTMS derivatized glass substrates; and
Figure 15 shows atomic force microscope images of the surface topography (a) and conductivity (b) of an 8.4 nm Au film on an MPTMS : APTMS monolayer derivatized glass substrate, as well as a histogram (c) and cross-section (d) of a step edge where the Au film was partially removed.

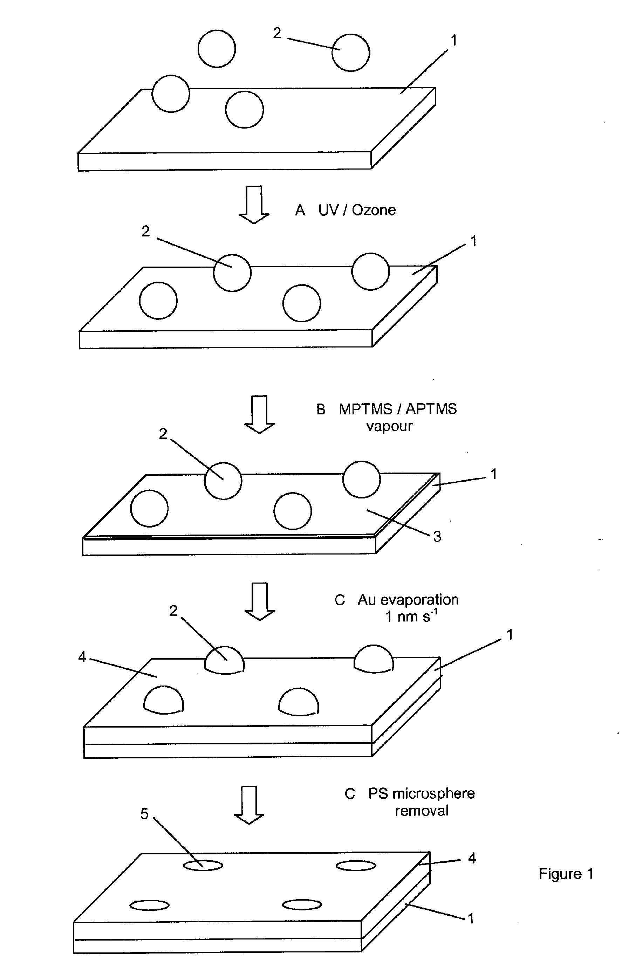

Referring now to Figure 1 there is shown in outline a process in accordance with the invention. A substrate 1 of glass or a plastic is provided, together with polystyrene microspheres 2 of mean diameter about 2 microns. At step A the microspheres 2 are deposited onto the substrate 1, and the substrate covered in randomly distributed microspheres is exposed to ozone (03) generated by the action of ultra-violet light on molecular oxygen. At step B there is vapour deposition on the substrate 1 of a mixture 3 of silanes, MPTMS and APTMS. This forms a mixed mono-molecular layer on the substrate. At step C there is vapour deposition of gold on the silane treated substrate, at a rate of about 1 nm per second, until a thin transparent film 4 about 8 nm thick has been formed. At step D the polystyrene microspheres 2 have been removed by the use of hot solvent vapour, to leave the thin film 4 of gold on the substrate 1, the gold film being perforated by an array of spaced apertures 5.

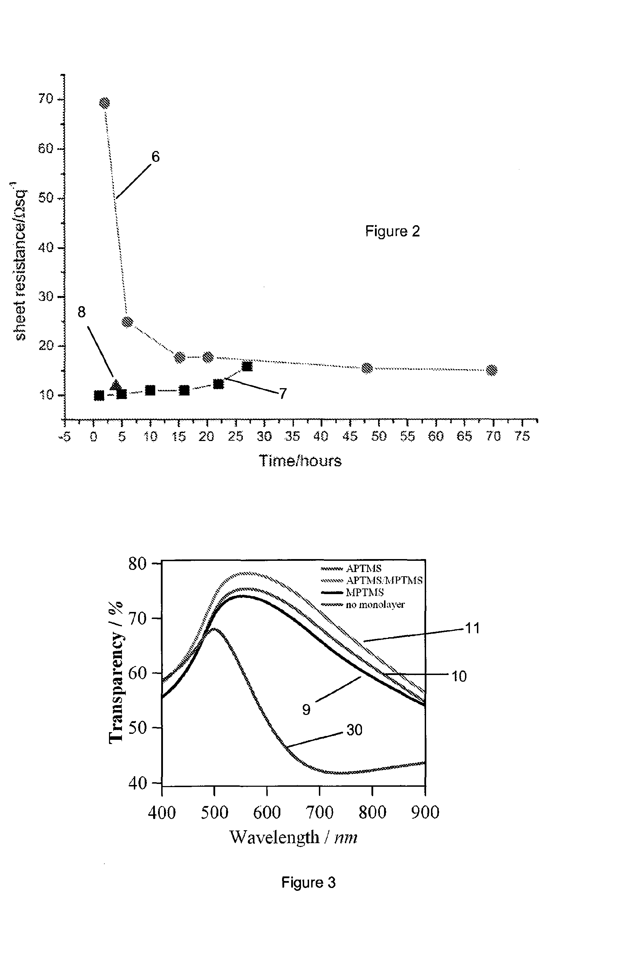

Figure 2 is a graph showing the sheet resistance of ultra-thin gold films deposited on MPTMS (curve 6) and APTMS (curve 7) derivatized glass substrates as a function of monolayer deposition time. The triangle 8 represents the sheet resistance of a metal film prepared on a mixed MPTMS :APTMS monolayer.

Figure 3 is a graph showing shows the transparency of gold films of the same thickness prepared on different silane layers. Curve 9 is for MPTMS, curve 10 for APTMS, curve 11 for a mixture of MPTMS and APTMS. Curve 30 relates to glass with a layer of Au of the same thickness, but without any silane layer at all. This shows how much difference a monolayer of silane makes to the transparency of the film.

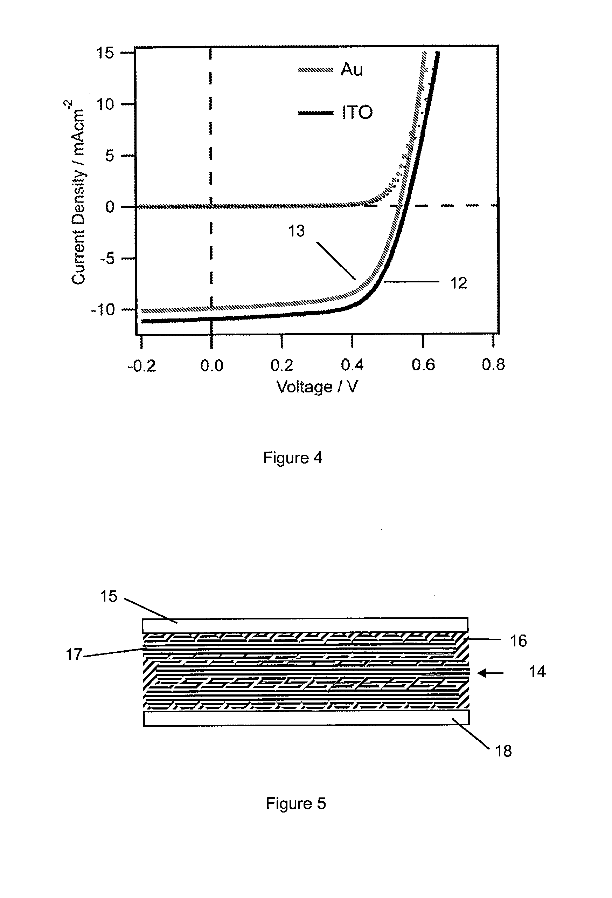

Figure 4 is a graph showing current-voltage characteristic of an OPV device using ITO glass as the transparent electrode (curve 12) and using an electrode in accordance with the invention having a perforated ultra-thin gold film supported on MPTMS : APTMS derivatized glass (curve 13) both under 1 sun simulated solar illumination. The upper set of curves shows the dark current-voltage characteristics. This figure shows the JV characteristics of OPVs with structure: 8.4 nm Au with 20 % aperture coverage (or ITO glass) / 7.5 nm WO₃/ P3HT:PCBM / 8 nm bathocuproine / 100 nm Al in the dark (dotted lines) and under AM1.5G simulated solar irradiance (solid lines).

To demonstrate the viability of these nano-structured electrodes as a direct replacement for ITO glass in OPVs they were incorporated into devices employing a WO₃ hole-extraction layer and a poly(3-hexylthiophene) (P3HT):[6,6]-phenyl-C61 butyric acid methyl ester (PCBM) bulk heterojunction photoactive layer. The latter is a well characterized photoactive material system for OPVs, capable of delivering power conversion efficiencies (η) of 4.4%.WO3 is an efficient hole-extraction material for OPVs although its lateral conductivity is significantly lower than the archetypal hole-extraction material poly(3,4-ethylenedioxythiophene) : poly(styrenesulfonate) (PEDOT:PSS). This combination of hole-extraction layer and photoactive layer is therefore ideally suited as a test bed to assess the suitability of these electrodes for OPVs. In our laboratory reference OPVs fabricated on ITO glass substrates exhibited η = 4.0 %. The η of PV devices is directly proportional to the product of the short-circuit current density (J_{sc}), the open-circuit voltage (V_{oc}) and the fill-factor (FF), where the latter is defined as the ratio between the maximum-power-point and the product J_{sc}.V_{oc}. It is evident from Figure 4 that OPVs employing an ultra-thin Au film electrode perforated with micron-sized holes covering 20% of the electrode surface exhibit a FF and V_{oc} (∼0.65 and ∼0.55 V respectively) comparable to that of OPV devices of the same structure employing an ITO glass electrode. The only significant difference in performance is a - 10 % lower J_{sc} which can be attributed to the difference in far-field transmittance. However, with optimization of the aperture density and diameter this relatively small difference can be significantly reduced.

Figure 5 is a diagrammatic view of an OPV device 14 comprising a transparent electrode 15 made in accordance with the invention, a donor semiconductor material 16, an acceptor semiconductor material 17, and a second electrode 18.

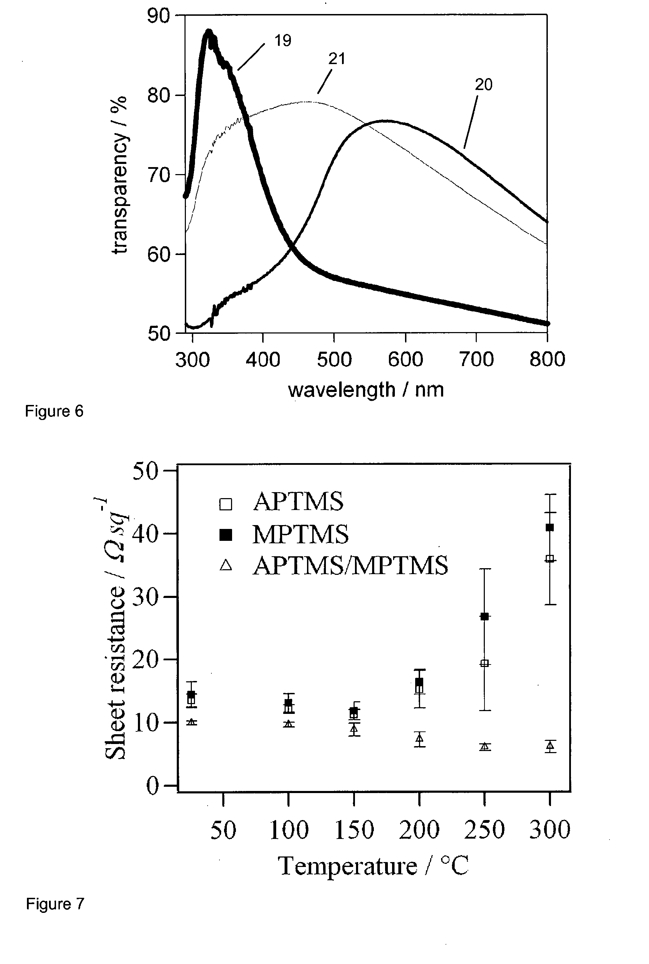

Figure 6 is a graph showing the transparency of three metal films as a function of the wavelength of light referenced to plain glass. The three films are all of the same thickness. Curve 19 shows the characteristics for a film of silver only, which exhibits a peak at around 300 nm to 350 nm. Curve 20 shows the characteristics for a film of gold only, with a peak at around 550 nm to 600 nm. Curve 21 shows the characteristics for a film of a gold and silver alloy. This shows that the mixture of the two metals provides a considerably broader band of transparency than either metal alone.

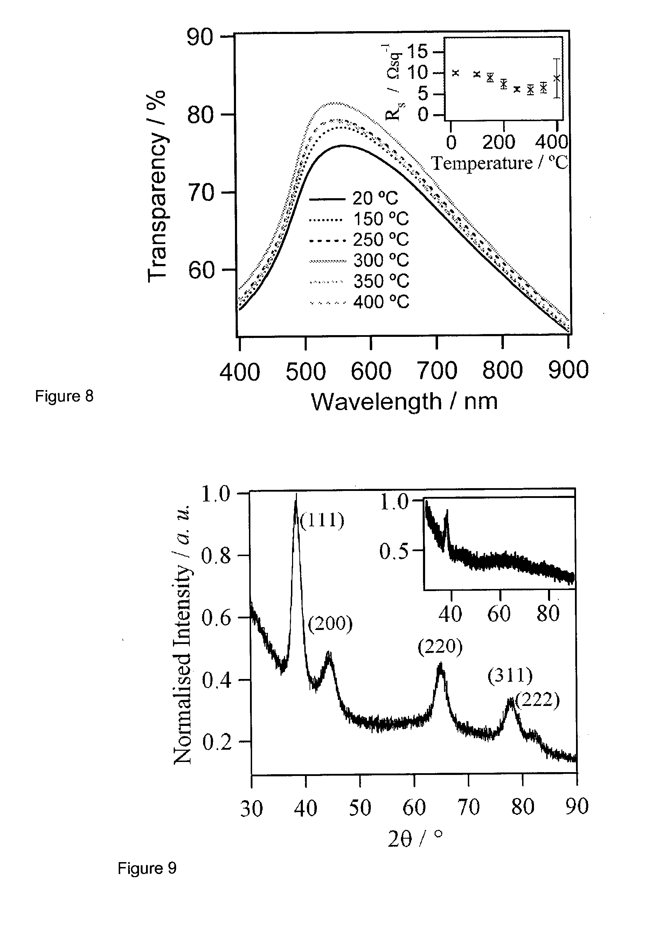

Figure 7 is a graph showing the effect on sheet resistance of annealing at various temperatures 8.4 nm Au films on glass substrates derivatized with different types of monolayer - (i) APTMS; (ii) MPTMS; and (iii) a mixture of the two. Figure 8 shows the effect of thermal annealing on both transparency and sheet resistance (inset) for an 8.4 nm film of Au on a glass substrate provided with an APTMS : MPTMS mixed monolayer.

Thus, the mixed molecular adhesive layer improves the ability to deal with elevated temperatures as compared to using either component alone, in terms of the sheet resistance being kept low. Furthermore annealing the metal film on the mixed monolayer also increases the transparency, as shown in Figure 8 which shows the effect of thermal annealing on the transparency (referenced to plain glass) and sheet resistance of 8.4 nm Au films on glass substrates derivatized with a monolayer of MPTMS : APTMS as a function of annealing temperature.

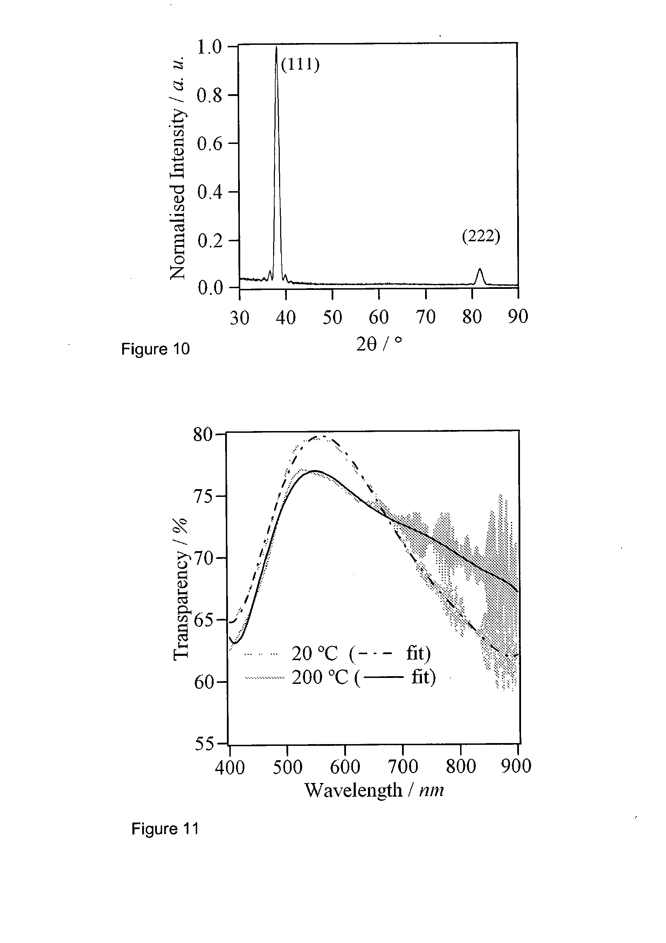

Figure 9 is a plot showing the grazing angle X-ray diffraction (XRD) spectra of non-annealed Au film (8.4 nm) on glass with an APTMS : MPTMS adhesive layer; and Figure 10 is a plot showing an XRD spectrum for on 8.4 nm Au film on glass with an APTMS :MPTMS adhesive layer after annealing to 300°C. It can be seen that the X-ray diffraction pattern changes upon annealing, to the extent that annealing the film causes the film to become more crystalline and that the surface becomes primarily composed of (111) crystal faces. This is an important advantage since makes the film surface very well-defined, which allows the interface with the adjacent organic semiconductor to be precisely engineered for optimal device performance.

It is believed that one of the reasons for the increase in transparency when the thin metal film is annealed is that as the temperature increases holes start to appear in the film. A scanning electron micrograph study of an 8.4 nm Au film on a mixed MPTMS : APTMS monolayer on glass shows that by annealing for 10 minutes at 300°C under nitrogen large holes (> 300 nm in diameter) appear. Annealing at a sufficiently high temperature is therefore an alternative way of introducing holes into the film, instead of using the microspheres.

In further embodiments of the invention, flexible PEN and PET substrates were used. These substrates were subjected to UV/O3 treatment. The incorporation of hydrophilic moieties at the polymer substrate surface upon UV/O3 treatment modifies the surface energy and so the optimal oxidation time was determined by measuring the static water contact angle as a function of UV/O3 treatment time. UV/O3 treated PEN samples were exposed to the vapour of APTMS : MPTMS under reduced pressure (- 5 mbar) for different times prior to evaporation of an Au film with an effective thickness of 8.4 nm. The films exhibited the highest transparency and lowest sheet resistance for a UV/O3 treatment time of 4 minutes and monolayer deposition time of 4 hours. Exposure to UV/O3 for extended periods increased the roughness of the substrate with Au film quality deteriorating rapidly after a UV/O3 treatment time of 15 minutes. PET films shows similar properties. On both PEN and PET the affect of UV/O3 treatment, as measured using high resolution X-ray photoelectron spectroscopy, was to increase the proportion of carbon atoms in the following chemical environments: C-OH, -C-O-C- and COO-C. On PET this proportion increased from -21% to ∼24%. On PEN this proportion increased from ∼14% to ∼22%. The composition of the mixed monolayer on both PET, PEN and glass substrates was 3.4 (± 0.1):1 APTMS : MPTMS as determined using high resolution X-ray photoelectron spectroscopy by measuring the ratio of the surface concentration of N to S.

Upon modification of the surface properties of the polymer substrates by UV/O3 treatment the silane end of the molecule attaches to the surface reactive hydroxyl groups forming siloxane linkages. Functional groups such as NH2-, SH- form covalent attachment to the gold and an ultra-thin gold film on a dense monolayer of mixed APTMS : MPTMS forms a robust, highly transparent and conductive film at low thickness (8.4 nm in this embodiment).

The properties of 8.4 nm Au films on PET and PEN are virtually identical and very close to those achieved on glass substrates: The sheet resistance is ∼ 12 (±2) Ω/sq and ∼13 (±2) Ω/sq on PEN and PET respectively, with average transparency in 400 nm - 750 nm region of 71 %, which is comparable to that on glass of ∼11 Ω/sq and 71 %. The film sheet resistance is six fold larger than that calculated on the basis of the resistivity of bulk Au (2.6 Ω/sq). This difference most likely results from increased scattering: (i) at the surface of the film, since the mean free path of electrons in bulk Au (∼36 nm) is a factor of four larger than the film thickness; (ii) and at crystal boundaries, since the high density of nucleation sites at the glass surface after treatment with a molecular adhesive promotes the formation of crystallites with small lateral dimensions.

Figure 11 is a graph showing the change in shape of the transmission spectrum of an 6.5 nm Au film on PEN derivatized with an MPTMS : APTMS monolayer before and after annealing to 200°C - the transparency is referenced to plain glass

The film's robustness towards standard substrate cleaning procedures was tested by subjecting to UV/O3 oxidative treatment and ultra-sonic agitation in three common solvents; namely, 2-propanol, toluene, and water. Remarkably, these films were resistant to all of the solvent treatments with no significant change in sheet resistance. The resistance of the films increased by ∼ 10% upon UV/O3 treatment consistent with the formation of a thin (∼ 1 nm) insulating oxide layer.

The performance of the Au films is comparable to the best alternative transparent electrodes combining a sheet resistance of ∼12 Ω/sq, high transparency (over 70 % between 400 nm - 750 nm), a low root-mean-square roughness of 1.5 nm, with a well-defined, chemically stable and uniform structure. The transparency and sheet resistance of these films may be tuned for particular application by changing the thickness of the film. In this way it is possible to obtain films with average transparency up to 74 % for 5.6 nm Au film (peak transparency 81 %) and sheet resistance of 12 Ω/sq for 8.4 nm Au film. Further increases in thickness may be beneficial for reduction in sheet resistance, while films thinner than 5.6 nm tend to suffer from lower continuity and high sheet resistance. The described method of producing ultra-thin Au films on flexible substrates is versatile and may be adapted to different polymers.

Substrate electrodes for OPVs are required to be robust towards elevated temperatures since in the field operational temperatures can exceed 60°C for extended periods and many photoactive material systems need to be annealed post-deposition to a temperature of 100-200°C to realise optimal efficiency. For both PET and PEN the onset of permanent deformation occurs at ∼ 200°C, placing an upper limit on the maximum processing temperature. To investigate the effect of elevated temperature on the performance of the ultra-thin Au films supported on silane derivatized PET and PEN, films with different effective thicknesses were annealed up to 200°C in a nitrogen atmosphere. It was found that these electrodes are exceptionally robust towards elevated temperature, and indeed the sheet resistance is reduced. Transparency spectra of 8.4 and 7.4 nm films reveals small changes after annealing of the film, while thinner films undergo significant transformation, as the transparency decreases around 500 nm and increases above 700 nm. Change in spectra shape is an indirect evidence of changes in morphology, influencing optical properties of the film. Annealing is therefore another way to tailor both electrical and optical properties of Au films.

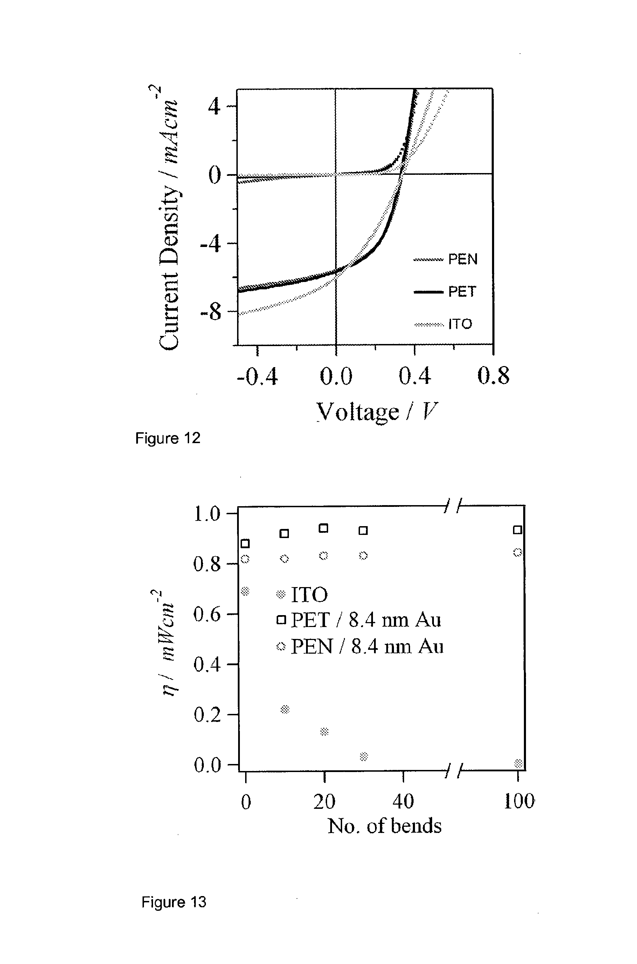

To demonstrate the viability of these electrodes as a drop-in replacement for ITO in flexible OPVs they were incorporated into discrete heterojunction OPVs based on a pentacene/C₆₀ junction and the performance compared directly with identical devices fabricated on commercially available ITO coated PET. This heterojunction was selected because it is one of the most widely studied and harvests photons across most of the visible spectrum, making it an excellent test bed for a comparative study of this kind. It is well known that relatively small differences in the nature of the substrate electrode can be critical determinants of device performance, since the growth mode of molecular semiconductors often exhibits a strong dependence on substrate surface energy and morphology. For this reason a 1 nm layer of 3,4,9,10-perylene-tetracarboxylic-dianhydride (PTCDA) was incorporated at the pentacene/electrode interface. This molecule is known to adopt the same orientation on both ITO and Au substrates and a 1 nm film is sufficiently thin to be transparent to electron transport across the interface. As a result any difference in device performance is unlikely to result from a difference in the morphology of the pentacene layer. The work function of freshly evaporated Au and freshly UV/O3 treated ITO was measured using the Kelvin probe technique to be 4.90 ± 0.05eV and 5.40 ± 0.15 eV respectively. After deposition of a 1 nm film of PTCDA this reduced to 4.60 ± 0.05eV and 4.9 ± 0.1 eV respectively consistent with previous reports. Sharma *et al.* [Sharma, A.; Haldi, A.; Potscavage, W. J.; Hotchkiss, P. J.; Marder, S. R.; Kippelen, B. Journal of Materials Chemistry 2009, 19, 5298.] have shown that the performance of pentacene/C₆₀ based OPVs is not affected by differences in the work function differences of the hole-extracting electrode over this range and so any difference in device performance cannot be attributed to differences in the interfacial energetics. Furthermore, so not to mask the critical role of sheet resistance in determining the performance of large area OPVs the device area was selected to be 1 cm². Typical device performance under 1 sun simulated solar illumination are shown in Figure 12. Devices fabricated on ITO coated PET substrates have a power conversion efficiency under 1 sun simulated solar illumination (*η*) = 0.64 ± 0.07 %. Devices fabricated on PEN / 8.4 nm Au and PET / 8.4 nm Au electrodes have a power conversion efficiency under 1 sun simulated solar illumination (*η*) of 0.83 ± 0.05 % and 0.85 ± 0.03 % respectively. The superior *η* in devices fabricated on ultra-thin Au electrodes results from the higher fill factor. The inferior fill factor in devices supported on ITO glass stems from the high sheet resistance of ITO films on PET (12-13 Ω/sq on 8.4 nm Au *vs*. > 40 Ω/sq on ITO) since the charge collection efficiency in OPVs is strongly voltage dependent. This result serves to highlight the importance of electrode sheet resistance in large area OPVs and demonstrates the advantage of ultra-thin Au electrodes on plastic substrates over ITO electrodes on plastics substrates. Furthermore, since the Au layer is evaporated this device structure can be fabricated in its entirety without breaking vacuum, offering a high degree of control over fabrication conditions and a potential cost advantage.

The upper set of curves on Figure 12 shows the dark current density / voltage characteristics.

Finally the mechanical properties of OPVs on ITO and Au electrodes on plastic substrates were evaluated as a function of number of bending cycles over a radius of curvature of 4 mm. The inherent brittleness of ITO electrodes causes them to fail quickly upon repeated bending - after only 10 bends the efficiency is reduced to 32 % of its initial value, whereas even after 100 bend cycles devices supported on 8.4 nm Au films on PET or PEN retain their starting efficiency.

Thus, in embodiments of the invention there is provided a rapid, solvent free method of making ultra-thin transparent Au electrodes on flexible substrates. These electrodes are smooth (root-mean-square roughness of ∼1.5 nm), highly transparent (average transparency in 400 nm - 750 nm region is above 70 %) and highly conductive (sheet resistance down to 12 Ω/sq). These electrodes were incorporated into pentacene / C60 based OPVs and the performance exceeded that of the same devices supported on ITO / PET electrodes, with the further advantage of dramatically enhanced resistance to repeated bending.

The gold can also be readily recouped from the OPV at the end of its life. Gold, due to its chemical properties and affinity to thiol/amine moieties, reveals best optical properties and high stability but the invention is not limited to the use of gold and other metals such as copper and silver, or mixtures of these metals, will be possible on both flexible polymer substrates and other substrates. The described method enables time and cost saving preparation of wholly evaporated devices on once pretreated substrates. By combining a continuous ultra-thin metal film with an array of thicker metal lines, ohmic losses caused by lateral currents can be kept to a minimum whilst maintaining a large broad band optical transmittance. The properties of these electrodes may be tailored for particular application through by the thickness of the film and annealing. This procedure is versatile and may be applied to different types of flexible substrates.

In some embodiments of the invention, 125 µm thick Hostaphan™ GN 4600 (Mitsubishi Polyester Film GMBH) and Teonex™ (DuPont Teijin Films UK Ltd) were cleaned by ultra-sonic agitation for 15 minutes firstly in a dilute aqueous solution of Decon Neutracon™ and then 2-propanol, followed by 4 minutes UV/O3 treatment to remove solvent residue and introduce hydroxyl groups onto the polymer surface. The substrates were immediately transferred to a dessicator where they were exposed to the vapor of APTMS : MPTMS at 5 mbar for 4 hours before transferring to the evaporator for Au deposition. The Au deposition rate was 0.1 nm s⁻¹. The thickness of deposited Au was measured using a carefully calibrated quartz-crystal micro-balance mounted adjacent to the substrate. Substrates were annealed on a hotplate under N₂.

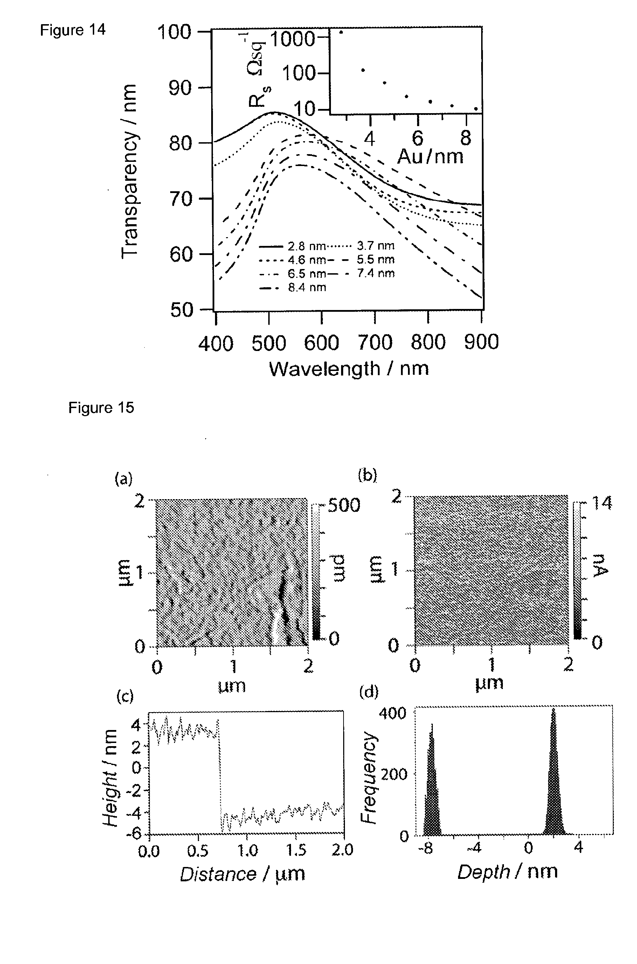

Figure 14 shows the transmittance spectra of Au films of different thickness deposited onto MPTMS : APTMS derivatized glass substrates. Inset is a plot showing the sheet resistance of Au films as a function of thickness.

Figure 15 shows atomic force microscope images of the surface topography (a) and conductivity (b) of an 8.4 nm Au film on an MPTMS : APTMS monolayer derivatized glass substrate. Also shown is a histogram (c) and cross-section (d) of a step edge where the Au film was partially removed.

In embodiments of the invention, there is provided a method of producing a transparent electrode suitable for use in an organic semiconductor photovoltaic device. First and second silanes are deposited from the vapour phase on a substrate and bind to the surface of the substrate. A metal film is then deposited from the vapour phase and binds to both the first and second silanes so as to produce a transparent metal layer having a thickness which is no greater than about 15 nanometres. The first silane is a non-amino functional silane and the second silane is an aminofunctional silane. The electrode may be flexible, using a polymer substrate. The metal film may be provided with a plurality of apertures, provided for example by masking the substrate with microspheres while depositing the metal and subsequently removing the microspheres, and / or annealing the metal so that apertures appear.

In general, in aspects of the invention where there is reference to the use of a silane, this extends to another type of molecular adhesive that has an anchor group that bonds to the substrate and a head group that bonds to the metal. For example, the silane anchor group could be replaced with an acid chloride (-COCI), sulfonyl chloride (-SO2Cl) or dichlorophosphate (-PO2O2) all of which have a high affinity for surface bound hydroxyl moieties. Where there is a reference to the use of a mixture of two silanes, this extends to the use of two such molecular adhesives. One may have an anchor group that bonds relatively quickly to the substrate, and one an anchor group that bonds relatively slowly. The faster bonding molecular adhesive may act as a catalyst to increase the speed of bonding of the slower bonding molecular adhesive when they are used together.

## Claims

1. A method of producing a transparent electrode suitable for use in a photovoltaic device, comprising the steps of co-depositing on a transparent substrate (1), from the vapour phase, first and second silanes (3) that bind to the surface of the substrate (1), and subsequently depositing from the vapour phase a metal film (4) which binds to both the first and second silanes (3) so as to produce a transparent metal layer (4) having a thickness which is no greater than about 15 nanometres, wherein the first silane is a non-amino functional silane and the second silane is an aminofunctional silane.

2. A method as claimed in claim 1, wherein the first silane comprises at least one anchor group which is a functional moiety capable of binding to the surface of the substrate (1) or which is hydrolysable to form such a moiety, and at least one head group selected from thiol (-SH), carboxy (-CO₂H), isocyanide (-NC) and organo-disulphide (-SS-R) groups (where R is H, C₁₋₆ alkyl or a silicon-containing group).

3. A method as claimed in claim 1 or 2, wherein the second silane comprises at least one anchor group which is a functional moiety capable of binding to the surface of the substrate (1) or which is hydrolysable to form such a moiety, and at least one head group which is an amine moiety.

4. A method as claimed in claim 1, 2 or 3, wherein the first silane has the formula (I): 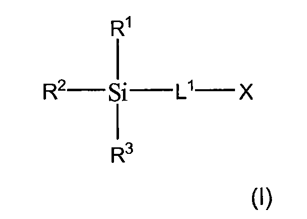 (wherein
L¹ is a linker group;
X is selected from -SH, -CO₂H, -NC and -SS-R where R is hydrogen, C₁₋₆ alkyl or a silicon-containing group); and
each of R¹ to R³ is independently an organic group having 1 to 12 carbon atoms, -OH, a group hydrolysable to -OH, or a group -L¹-X;
with the proviso that at least one of R¹, R² and R³ is -OH or a group hydrolysable to -OH).

5. A method as claimed in any preceding claim, wherein the second silane has the formula (II): 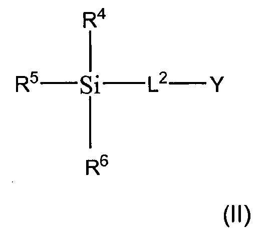 (wherein
L² is a linker group;
Y is -NH_{2;} and
each of R⁴ to R⁶ is independently an organic group having 1 to 12 carbon atoms, -OH, a group hydrolysable to -OH, or a group -L²-Y;
with the proviso that at least one of R⁴, R⁵ and R⁶ is -OH or a group hydrolysable to -OH).

6. A method as claimed in any preceding claim wherein the first silane is 3-mercaptopropyltrimethoxysilane and the second silane is 3-aminopropyltrimethoxysilane.

7. A method as claimed in any preceding claim, wherein the electrode is flexible and the substrate (1) is a flexible polymer.

8. A method as claimed in any preceding claim, wherein the sheet resistance of the metal film (4) is no more than about 100 ohms per square.

9. A method as claimed in any preceding claim, wherein the metal film (4) is provided with an array of apertures (5), each having a diameter of no less than about 300 nm.

10. A method as claimed in claim 9, wherein the apertures (5) are produced by heat treatment of the metal layer (4).

11. A method as claimed in any of claims 1 to 9, wherein the metal layer (4) is annealed.

12. A method as claimed in any preceding claim, wherein the metal film (4) is of gold; or silver; or copper; or a mixture of at least two of these.

13. A method of producing a transparent electrode suitable for use in a photovoltaic device, comprising the steps of depositing on a transparent substrate (1), from the vapour phase, a silane (3) that binds to the surface of the substrate (1), and depositing from the vapour phase a metal which binds to the silane so as to produce a transparent metal layer (4), having a thickness which is no greater than about 15 nanometres, wherein the silane (3) comprises both amino and non-amino functionalities.

14. A method of producing a photovoltaic device (14) comprising combining a transparent electrode (15) produced by a method as claimed in any preceding claim with a donor semiconductor material (16), an acceptor semiconductor material (17), and a second electrode (18).

15. A method as claimed in claim 14, wherein at least one of the semiconductor materials (16, 17) is an organic semiconductor material.

## Patentansprüche

1. Verfahren zum Erzeugen einer transparenten Elektrode, die zur Verwendung in einer photovoltaischen Vorrichtung geeignet ist, umfassend die Schritte eines gemeinsamen Abscheidens erster und zweiter Silane (3) aus der Dampfphase auf eine transparente Trägerschicht (1), die an die Oberfläche der Trägerschicht (1) binden, und eines anschließenden Abscheidens eines Metallfilms (4) aus der Dampfphase, der sowohl an das erste wie auch zweite Silan (3) bindet, um somit eine transparente Metallschicht (4) mit einer Dicke zu bilden, die nicht größer als etwa 15 Nanometer ist, wobei das erste Silan ein nicht-aminofunktionelles Silan ist und das zweite Silan ein aminofunktionelles Silan ist.

2. Verfahren nach Anspruch 1, wobei das erste Silan mindestens eine Ankergruppe umfasst, die ein funktioneller Rest ist, der zur Bindung an die Oberfläche der Trägerschicht (1) imstande ist, oder die hydrolysierbar ist, um einen solchen Rest zu bilden, und mindestens eine Kopfgruppe, ausgewählt aus Thiol- (-SH), Carboxy- (-CO₂H), Isocyanid- (-NC) und Organodisulphid- (-SS-R) Gruppen (wobei R H, C₁₋₆-Alkyl oder eine siliziumhältige Gruppe ist).

3. Verfahren nach Anspruch 1 oder 2, wobei das zweite Silan mindestens eine Ankergruppe umfasst, die ein funktioneller Rest ist, der zur Bindung an die Oberfläche der Trägerschicht (1) imstande ist, oder die hydrolysierbar ist, um einen solchen Rest zu bilden, und mindestens eine Kopfgruppe, die ein Aminrest ist.

4. Verfahren nach Anspruch 1, 2 oder 3, wobei das erste Silan die Formel (I) hat: 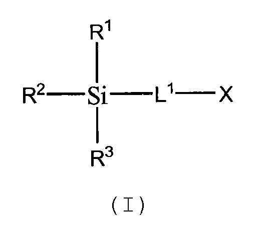 (wobei
L¹ eine Linkergruppe ist;
X ausgewählt ist aus -SH, -CO₂H, -NC und -SS-R, wobei R Wasserstoff, C₁₋₆-Alkyl oder eine siliziumhältige Gruppe ist); und
jedes von R¹ bis R³ unabhängig eine organische Gruppe mit 1 bis 12 Kohlenstoffatomen, -OH, eine Gruppe, die zu -OH hydrolysierbar ist, oder eine Gruppe -L¹-X ist;
unter der Voraussetzung, dass mindestens eines von R¹, R² und R³ -OH oder eine Gruppe ist, die zu -OH hydrolysierbar ist).

5. Verfahren nach einem vorangehenden Anspruch, wobei das zweite Silan die Formel (II) hat: 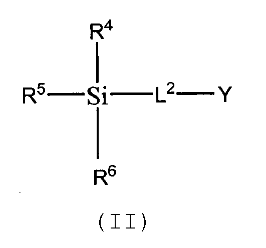 (wobei
L² eine Linkergruppe ist;
Y -NH₂ ist; und
jedes von R⁴ bis R⁶ unabhängig eine organische Gruppe mit 1 bis 12 Kohlenstoffatomen, -OH, eine Gruppe, die zu -OH hydrolysierbar ist, oder eine Gruppe -L²-Y ist;
unter der Voraussetzung, dass mindestens eines von R⁴, R⁵ und R⁶ -OH oder eine Gruppe ist, die zu -OH hydrolysierbar ist).

6. Verfahren nach einem vorangehenden Anspruch, wobei das erste Silan 3-Mercaptopropyltrimethoxysilan ist und das zweite Silan 3-Aminopropyltrimethoxysilan ist.

7. Verfahren nach einem vorangehenden Anspruch, wobei die Elektrode flexibel ist und die Trägerschicht (1) ein flexibles Polymer ist.

8. Verfahren nach einem vorangehenden Anspruch, wobei der Schichtwiderstand des Metallfilms (4) nicht mehr als etwa 100 Ohm pro Quadrat ist.

9. Verfahren nach einem vorangehenden Anspruch, wobei der Metallfilm (4) mit einer Anordnung von Öffnungen (5), jeweils mit einem Durchmesser von nicht weniger als etwa 300 nm, versehen ist.

10. Verfahren nach Anspruch 9, wobei die Öffnungen (5) durch Wärmebehandlung der Metallschicht (4) erzeugt werden.

11. Verfahren nach einem der Ansprüche 1 bis 9, wobei die Metallschicht (4) getempert ist.

12. Verfahren nach einem vorangehenden Anspruch, wobei der Metallfilm (4) aus Gold; oder Silber; oder Kupfer; oder einem Gemisch aus mindestens zwei von diesen besteht.

13. Verfahren zur Herstellung einer transparenten Elektrode die zur Verwendung in einer photovoltaischen Vorrichtung geeignet ist, umfassend die Schritte eines Abscheidens eines Silans (3) aus der Dampfphase auf eine transparente Trägerschicht (1), das an die Oberfläche der Trägerschicht (1) bindet, und eines Abscheidens eines Metalls aus der Dampfphase, das an das Silan bindet, um somit eine transparente Metallschicht (4) mit einer Dicke zu bilden, die nicht größer als etwa 15 Nanometer ist, wobei das Silan (3) sowohl Amin- wie auch Nicht-Aminfunktionalitäten umfasst.

14. Verfahren zur Herstellung einer photovoltaischen Vorrichtung (14), umfassend ein Kombinieren einer transparenten Elektrode (15), die durch ein Verfahren nach einem vorangehenden Anspruch hergestellt wurde, mit einem Donor-Halbleitermaterial (16), einem Akzeptor-Halbleitermaterial (17) und einer zweiten Elektrode (18).

15. Verfahren nach Anspruch 14, wobei mindestens eines der Halbleitermaterialien (16, 17) ein organisches Halbleitermaterial ist.

## Revendications

1. Procédé de production d'une électrode transparente convenant à une utilisation dans un dispositif photovoltaïque, comprenant les étapes consistant à co-déposer sur un substrat transparent (1), à partir de la phase vapeur, un premier et un second silane (3) qui se lient à la surface du substrat (1) et à déposer ensuite à partir de la phase vapeur un film métallique (4) qui se lie à la fois au premier et au second silane (3) de manière à produire une couche métallique transparente (4) ayant une épaisseur qui n'est pas supérieure à environ 15 nanomètres, dans lequel le premier silane est un silane non amino fonctionnel et le second silane est un silane amino fonctionnel.

2. Procédé selon la revendication 1, dans lequel le premier silane comprend au moins un groupement d'ancrage qui est une fraction fonctionnelle capable de se lier à la surface du substrat (1) ou qui est hydrolysable pour former une telle fraction, et au moins un groupement de tête choisi parmi les groupements thiol (-SH), carboxy (-CO₂H), isocyanure (-NC) et organodisulfure (-SS-R) (où R est H, un groupement alkyle en C₁-C₆ ou un groupement contenant du silicium).

3. Procédé selon la revendication 1 ou la revendication 2, dans lequel le second silane comprend au moins un groupement d'ancrage qui est une fraction fonctionnelle capable de se lier à la surface du substrat (1) ou qui est hydrolysable, pour former une telle fraction et au moins un groupement de tête qui est une fraction amino.

4. Procédé selon la revendication 1, 2 ou 3, dans lequel le premier silane a la formule (I) : 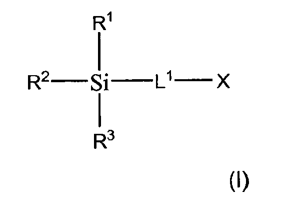 (dans laquelle :
L¹ est un groupement lieur ;
X est choisi parmi -SH, -CO₂H, -NC et -SS-R, où R est de l'hydrogène, un groupement alkyle en C₁-C₆ ou un groupement contenant du silicium ; et
chacun des groupements R¹ à R³ est indépendamment un groupement organique ayant 1 à 12 atomes de carbone, -OH, un groupement hydrolysable en -OH ou un groupement -L¹-X ;
à condition que le au moins un des groupements R¹, R² et R³ soit -OH ou un groupement hydrolysable en -OH).

5. Procédé selon l'une quelconque des revendications précédentes, dans lequel le second silane a la formule (II) : 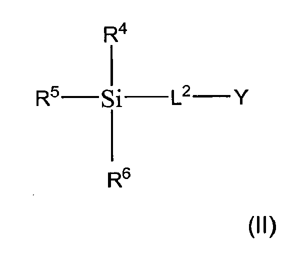 (dans laquelle :
L² est un groupement lieur ;
Y est -NH₂ ; et
chacun des groupements R⁴ à R⁶ est indépendamment un groupement organique ayant 1 à 12 atomes de carbone, -OH, un groupement hydrolysable en -OH ou un groupement -L²-Y ;
à condition que le au moins un des groupements R⁴, R⁵ et R⁶ soit -OH ou un groupement hydrolysable en -OH).

6. Procédé selon l'une quelconque des revendications précédentes, dans lequel le premier silane est le 3-mercaptopropyltriméthoxysilane et le second silane est le 3-aminopropyltriméthoxysilane.

7. Procédé selon l'une quelconque des revendications précédentes, dans lequel l'électrode est flexible et le substrat (1) est un polymère flexible.

8. Procédé selon l'une quelconque des revendications précédentes, dans lequel la résistance de feuille du film métallique (4) n'est pas supérieure à environ 100 ohms par carré.

9. Procédé selon l'une quelconque des revendications précédentes, dans lequel le fil métallique (4) est pourvu d'un réseau d'ouvertures (5), chacune d'elles ayant un diamètre de pas moins d'environ 300 nm.

10. Procédé selon la revendication 9, dans lequel les ouvertures (5) sont produites par traitement thermique de la couche métallique (4).

11. Procédé selon l'une quelconque des revendications 1 à 9, dans lequel la couche métallique (4) est recuite.

12. Procédé selon l'une quelconque des revendications précédentes, dans lequel le fil métallique (4) est formé d'or ; ou d'argent ; ou de cuivre ; ou d'un mélange d'au moins deux d'entre eux.

13. Procédé de production d'une électrode transparente convenant à une utilisation dans un dispositif photovoltaïque, comprenant les étapes consistant à déposer sur un substrat transparent (1) à partir de la phase vapeur un silane (3) qui se lie à la surface du substrat (1) et à déposer à partir de la phase vapeur un métal qui se lie au silane de manière à produire une couche métallique transparente (4) ayant une épaisseur qui n'est pas supérieure à environ 15 nanomètres, dans lequel le silane (3) comprend des fonctionnalités à la fois amino et non amino.

14. Procédé de production d'un dispositif photovoltaïque (14) comprenant la combinaison d'une électrode transparente (15) produite par un procédé selon l'une quelconque des revendications précédentes avec un matériau semi-conducteur donneur (16), un matériau semi-conducteur accepteur (17) et une seconde électrode (18).

15. Procédé selon la revendication 14, dans lequel au moins l'un des matériaux semi-conducteurs (16, 17) est un matériau semi-conducteur organique.
